# EUROPÄISCHE PATENTSCHRIFT

(11) **EP 1 440 496 B1**
(45) Veröffentlichungstag und Bekanntmachung des Hinweises auf die Patenterteilung: **27.07.2005**
(21) Anmeldenummer: 01274614.5
(22) Anmeldetag: 15.10.2001
(51) Int. Cl.: H01S 5/026

(54) **LASERDIODENEINHEIT UND ANORDNUNG ZUM BETREIBEN EINER LASERDIODE**
LASER DIODE ASSEMBLY AND DEVICE FOR OPERATING A LASER DIODE
ENSEMBLE DIODE LASER ET DISPOSITIF POUR FAIRE FONCTIONNER UNE DIODE LASER

(43) Veröffentlichungstag der Anmeldung: 28.07.2004
(73) Patentinhaber: Infineon Technologies AG, 81669 München (DE)
(72) Erfinder: SCHROEDINGER, Karl, 14089 Berlin (DE); OHEIM, Toralf, 16761 Henningsdorf (DE)
(74) Vertreter: Müller, Wolfram Hubertus, Dr. Dipl.-Phys.
(86) Internationale Anmeldenummer: PCT/DE2001/003948
(87) Internationale Veröffentlichungsnummer: WO 2003/038955

(56) Entgegenhaltungen:
- WO-A-01/59814
- DD-A- 159 584
- US-A- 4 845 723
- PATENT ABSTRACTS OF JAPAN vol. 1996, no. 09, 30. September 1996 (1996-09-30) & JP 08 116136 A (HITACHI LTD;HITACHI TOBU SEMICONDUCTOR LTD), 7. Mai 1996 (1996-05-07)

## Beschreibung

Die Erfindung betrifft eine Laserdiodeneinheit mit einer Koppelkapazität.

Um möglichst kleine Verlustleistungen zu erreichen, werden integrierte Schaltkreise (ICs) zur Ansteuerung von Laserdioden für immer kleiner werdende Versorgungsspannungen entwickelt. Eine weitere Motivation für kleinere Versorgungsspannungen sind Durchbruchkriterien mancher der verwendeten integrierten Bauteile.

Der Arbeitspunkt einer anzusteuernden Laserdiode wird durch einen Schwellstrom und einen Modulationsstrom eingestellt, wobei der Modulationsstrom den Datenstrom darstellt. Die Ströme erzeugen einen Spannungsabfall an der Laserdiode. Der Spannungsabfall an der Diode kann so groß sein, dass der Laser auf Grund der begrenzenden Versorgungsspannung vom Lasertreiber-IC nicht mehr direkt getrieben werden kann.

Ist der Spannungsabfall an der Laserdiode so groß, dass der Laser auf Grund der begrenzten Versorgungsspannung bzw. der notwendigen Spannungsabfälle an den Treibertransistoren vom Lasertreiber-IC nicht mehr direkt getrieben werden kann, so ist es bekannt, die Modulation der Laserdiode mittels einer Koppelkapazität erfolgen zu lassen. Bei der Modulation und Übertragung der Daten im Hochfrequenzbereich treten jedoch an den Koppelstrecken sowohl vom Modulationsausgang des Lasertreiber-ICs zum Koppelkondensator als auch vom Koppelkondensator zur Laserdiodenkoppeleinheit Verluste und Fehlanpassungen durch parasitäre Elemente auf. Diese parasitären Elemente können unter anderem Bonddrahtinduktivitäten und Padkapazitäten sein.

Aus der DD-A-159 584 ist eine intermittierend strahlende Lumineszenz- oder Laserdiodenanordnung bekannt, bei der ein Lumineszenzdiodenchip auf einem Träger angeordnet ist. Zwischem dem Träger und dem Lumineszenzdiodenchip befindet sich eine Kapazität, die mit einem Signal beaufschlagt wird. Bei dem Träger handelt es sich um einen integrierten Schaltkreis.

Der vorliegenden Erfindung liegt die Aufgabe zu Grunde, eine Laserdiodeneinheit zur Verfügung zu stellen, bei der bei Verwendung einer Koppelkapazität zwischen Lasertreiber-Schaltung und Laserdiode das Auftreten parasitärer Elemente vermindert wird.

Diese Aufgabe wird erfindungsgemäß durch eine Laserdiodeneinheit gelöst, die mindestens eine Laserdiode, einen integrierten Schaltkreis mit einer Oberfläche, auf dem die Laserdiode angeordnet oder monolithisch ausgebildet ist, Anschlusskontakte für die Laserdiode und mindestens eine Koppelkapazität, die in den integrierten Schaltkreis integriert ist, aufweist. Dabei weist die Koppelkapazität eine erste, an der Oberfläche des integrierten Schaltkreises ausgebildete Metallisierung und eine zweite, im,Inneren des integrierten Schaltkreises ausgebildete Metallisierung auf, wobei letzere Metallisierung mit einem Kontakt an einer Oberfläche des integrierten Schaltkreises verbunden ist. Die Laserdiode wird über die Koppelkapazität mit einem Signal einer Lasertreiber-Schaltung beaufschlagt.

Bevorzugte und vorteilhafte Ausgestaltungen der Erfindung sind in den Unteransprüchen angegeben.

Danach ist somit vorgesehen, die zwischen dem Ausgang einer Lasertreiber-Schaltung und der Laserdiode angeordnete Koppelkapazität in die Laserdiodeneinheit zu integrieren. Dies weist den Vorteil auf, dass die Anzahl der problematischen Koppelstrecken von der Lasertreiber-Schaltung bis hin zur Laserdiodeneinheit reduziert und das Auftreten parasitäter Elemente vermindert wird. So fällt auf Grund der Integration der Koppelkapazität in die Laserdiodeneinheit eine gesonderte Koppelstrecke zwischen der Laserdiodeneinheit und einer externen Koppelkapazität, wie sie im Stand der Technik vorgesehen ist, weg. Dieser Vorteil kann sowohl für die einfache (single-ended) als auch für die differentielle Ansteuerung einer Laserdiode bzw. eines Laserdioden-Arrays genutzt werden.

Es ist somit möglich, die Modulationsausgänge einer Lasertreiber-Schaltung, die in der Regel als integrierter Schaltkreis ausgebildet ist, direkt mit der Laserdiodeneinheit zu verbinden, beispielsweise durch Bonddrähte oder mittels einer Chip-on-Chip-Montage.

Unter einem Laserdioden-Array wird eine Anordnung mehrerer Laserdioden in einem mechanischen Verbund verstanden. Die Laserdiodeneinheit wird für diesen Fall durch das Laserdioden-Array, einen Träger für das Laserdioden-Array, elektrische Anschlusskontakte und mindestens eine Koppelkapazität gebildet.

In einer bevorzugten Ausgestaltung der Erfindung ist vorgesehen, dass die Laserdiode mit einem Anschluss direkt (z.B. durch Klebung) auf eine Metallisierung auf der Oberfläche des integrierten Schaltkreises gesetzt ist, die einen Kontakt der Koppelkapazität bildet. Der andere Anschluss der Laserdiode wird bevorzugt durch einen kurzen Bondraht realisiert.

In einer vorteilhaften Weiterbildung der Erfindung ist auch die Lasertreiber-Schaltung in den integierten Schaltkreis integriert bzw. handelt es sich bei der integrierten Schaltung um den Lasertreiber-IC, d.h. die mindestens eine Koppelkapazität ist in den Lasertreiber-IC mit integriert. Die Montage der Laserdiode bzw. des Laserdiodenchips erfolgt direkt auf dem Lasertreiber-IC, wobei die Laserdiode mit mindestens einem Anschluss mit der Metallisierung des Lasertreiber-IC's verbunden ist und der andere Anschluss durch einen besonders kurzen Bonddraht realisiert wird.

Die Erfindung wird nachfolgend unter Bezugnahme auf die Figuren der Zeichnung anhand mehrerer Ausführungsbeispiele näher erläutert. Es zeigen:
- Figur 1: schematisch den Aufbau einer Laserdiodeneinheit mit integrierter Koppelkapazität, wobei die Laserdiodeneinheit einen p-Kontakt-Laserdiodenchip in einfacher Ansteuerung aufweist;
- Figur 2: ein Beispiel entsprechend Figur 1 mit einem n-Kontakt-Laserdiodenchip;
- Figur 3: schematisch den Aufbau einer Laserdiodeneinheit mit integrierter Koppelkapazität, wobei die Laserdiodeneinheit einen p-Kontakt-Laserdiodenchip in einfacher Ansteuerung aufweist;
- Figur 4: ein Beispiel entsprechend Figur 3 mit einem n-Kontakt-Laserdiodenchip;
- Figur 5: schematisch den Aufbau einer Laserdiodeneinheit mit integrierter Koppelkapazität, wobei die Laserdiodeneinheit einen p-Kontakt-Laserdiodenchip in einfacher Ansteuerung aufweist;
- Figur 6: ein Beispiel entsprechend Figur 5 mit einem n-Kontakt-Laserdiodenchip;
- Figur 7: schematisch den Aufbau einer Laserdiodeneinheit mit integrierter Koppelkapazität, wobei die Laserdiodeneinheit einen p-Kontakt-Laserdiodenchip in differentieller Ansteuerung aufweist;
- Figur 8: ein Beispiel entsprechend Figur 7 mit einem n-Kontakt-Laserdiodenchip;
- Figur 9: schematisch den Aufbau einer Laserdiodeneinheit mit integrierter Koppelkapazität, wobei die Laserdiodeneinheit einen p-Kontakt-Laserdiodenchip in differentieller Ansteuerung aufweist;
- Figur 10: ein Beispiel entsprechend Figur 9 mit einem n-Kontakt-Laserdiodenchip;
- Figur 11: schematisch den Aufbau eines Ausführungsbeispiels einer Laserdiodeneinheit mit integrierter Koppelkapazität, wobei die Koppelkapazität in einen Lasertreiber-IC integriert ist und ein p-Kontakt-Laserdiodenchip in differentieller Ansteuerung verwendet wird und
- Figur 12: ein Ausführungsbeispiel gemäß Figur 11 mit einem n-Kontakt-Laserdiodenchip.

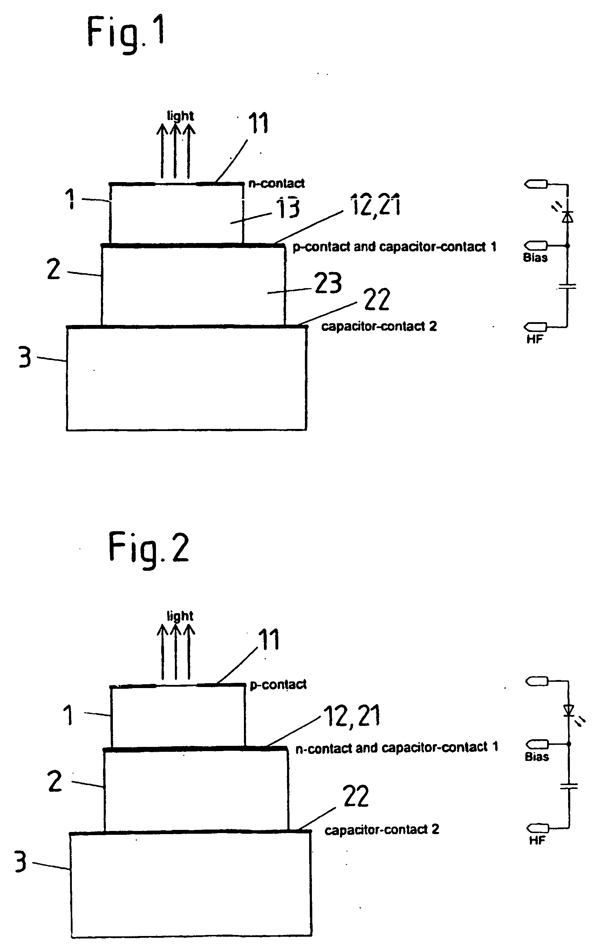

Gemäß Figur 1 bilden ein auch als Laserdiode bezeichneter Laserdiodenchip 1, eine Koppelkapazität 2, ein Träger/Submount 3 sowie zugehörige elektrische Anschlusskontakte eine Laserdiodeneinheit 100. Die Laserdiodeneinheit kann wahlweise zusätzlich mit einem Gehäuse (nicht dargestellt) umgeben und durch dieses gegenüber der Umgebung gekapselt sein.

In dem Beispiel der Figur 1 ist die Koppelkapazität 2 zwischen dem Submount 3 und der Laserdiode 1 angeordnet, d.h. die Koppelkapazität 2 ist direkt auf dem Subount 3 und die Laserdiode 1 direkt auf die Koppelkapazität 2 montiert.

Die Laserdiode 1 weist in an sich bekannter Weise eine Halbleiterlaserstruktur 13, einen oberen n-Kontakt 11 und einen unteren p-Kontakt 12 auf. Die beiden Kontakte 11, 12 werden durch metallische Flächen gebildet. Es handelt sich bei der Laserdiode 1 bevorzugt um eine vertikal emittierende Diode. Grundsätzlich können jedoch beliebige Laserdioden verwendet werden.

Die Koppelkapazität 2 ist als Chipkapazität ausgebildet. Die Kondensatorflächen der Koppelkapazität 3 werden durch metallisierte Kontaktflächen 21, 22 an den gegenüberliegenden Seiten eines Chips 23 ausgebildet, der auf den Submount 3 aufgesetzt ist. Der Submount 3 ist ein hochohmiges Substrat mit einer geringen parasitären Kapazität.

Wie dem Schaltungsbild auf der rechten Seite der Figur 1 zu entnehmen ist, erfährt die Laserdiode 1 eine einfache (single-ended) Ansteuerung mit einem Hochfrequenz (HF)-Modulationsstrom, der entsprechend einem zu übertragenden Datensignal moduliert ist. Der HF-Modulationsstrom wird von einer Laserdioden-Treiberschaltung erzeugt und beispielsweise über einen Bonddraht auf den unteren Kontakt 22 der Koppelkapazität 2 gelegt. Über den oberen Kontakt 21 der Koppelkapazität 2 wird ein Bias-Strom an die Laserdiode 1 angelegt. Der Bias-Strom ist dabei ausreichend groß, dass auch bei einer kleinen Versorgungsspannung der Laserdioden-Treiberschaltung von beispielsweise 3.3 V die Laserdiode 1 direkt betrieben werden kann.

Der obere Kontakt 21 der Koppelkapazität 2 ist gleichzeitig der n-Kontakt 12 des Laserdiodenchips 1. Der p-Kontakt 11 des Laserdiodenchips 1 ist auf der oberen Seite des Laserdiodenchips 1 angebracht und auf ein elektrisches Bezugspotential gelegt.

Eine Kontaktierung der Laserdiodeneinheit 100 erfolgt über eine direkte Verbindung der entsprechenden Ausgänge der Lasertreiber-Schaltung mit den Kontakten 22, 21 der Koppelkapazität 2 bzw. den Kontakten 11, 12 des Laserdiodenchips 1, beispielsweise über Bonden. Es ist somit möglich, die Ausgänge der Lasertreiberschaltung direkt mit der Laserdiodeneinheit zu verbinden.

In dem Beispiel der Figur 2 handelt es sich statt um eine p-Kontakt-Laserdiode um eine n-Kontakt-Laserdiode, deren unterer Kontakt 12 der p-Kontakt und deren oberer Kontakt 11 der n-Kontakt ist. Ansonsten bestehen keine Unterschiede zu der Ausführung der Figur 1.

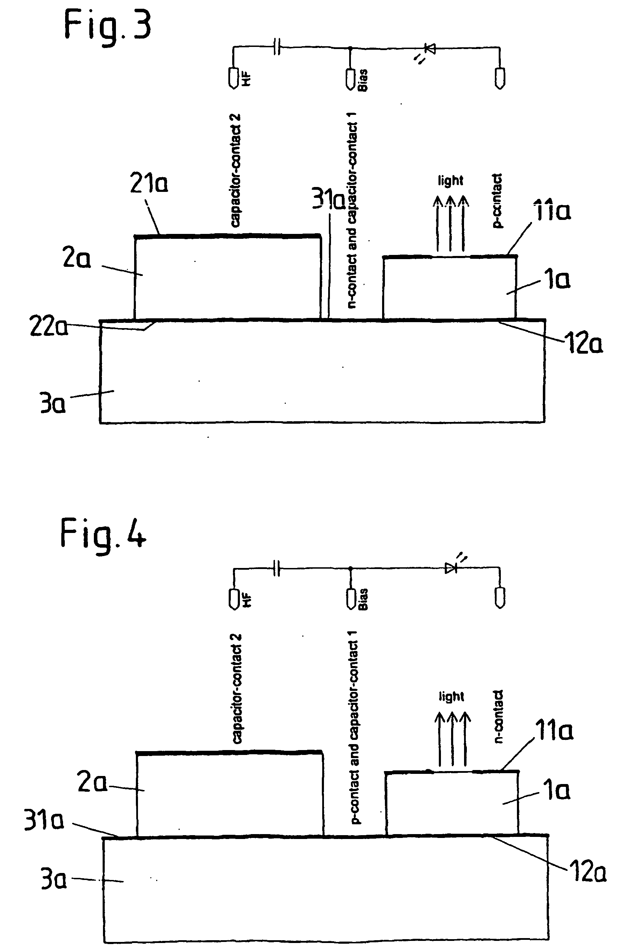

In dem Beispiel der Figur 3 ist die Koppelkapazität 2a wiederum als Chip-Kapazität mit einem oberen Kontakt 21a und einem unteren Kontakt 22a ausgebildet. Die Koppelkapazität 2a ist jedoch neben dem p-Kontakt-Laserdiodenchip 1a auf dem Submount 3a angeordnet. Auf der Oberfläche des Submounts 3a ist dabei eine durchgehende Kontaktierung 31a vorgesehen, die sowohl die untere Kontaktierung 22a des Koppelkondensator 2a als auch den n-Kontakt 12a der Laserdiode 1 umfasst und über die der Bias-Strom angelegt wird. Der HF-Modulationsstrom wird über den oberen Kontakt 21a der Koppelkapazität zugeführt. Der p-Kontakt 11 der Laserdiode 1 ist wiederum auf ein elektrisches Bezugspotential gelegt.

Im übrigen wird auf die Ausführungen zu Figur 1 verwiesen. Beim Beispiel der Figur 4 besteht der einzige Unterschied zum Ausführungsbeispiel der Figur 3 wiederum in der Ausbildung der Laserdiode als n-Kontakt-Laserdiode. Dementsprechend liegt die gemeinsame Kontaktierung 31a am p-Kontakt des Laserdiodenchips 1a.

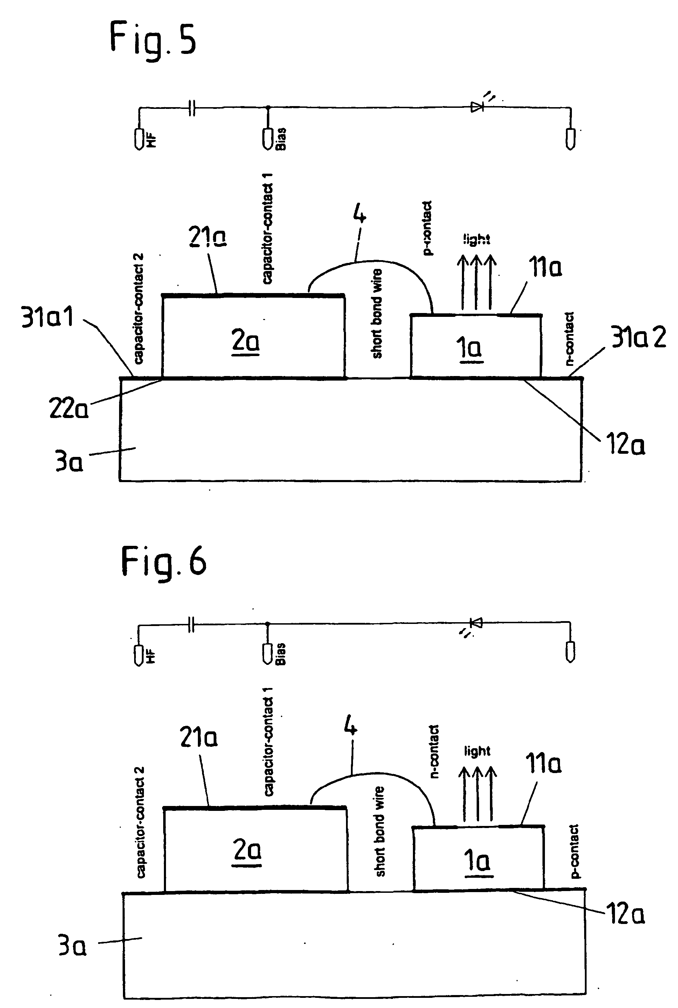

Das Beispiel der Figur 5 zeigt ein zu dem Ausführungsbeispiel der Figur 3 insofern alternatives Ausführungsbeispiel, als keine gemeinsame Kontaktierung auf der Oberfläche des Submounts 3a vorgesehen ist. Das Hochfrequenzsignal wird bei diesem Ausführungsbeispiel an einen Kontaktpin 31a1 auf dem Submount 3a angelegt, der mit dem unteren Kontakt 22a der Koppelkapazität 2a verbunden ist. An den oberen Kontakt 21a der Koppelkapazität 2a wird der Bias-Strom angelegt. Die Kontaktierung des p-Kontakts 11a des Laserdiodenchips 1a erfolgt einen kurzen Bonddraht 4 vom oberen Kontakt 21a der Koppelkapazität 2a. Der untere n-Kontakt 12a der Laserdiode 1a ist über einen weiteren Kontaktpin 31a2 auf ein elektrisches Bezugspotential gelegt. Bei diesem Beispiel ist somit der p-Kontakt 11a der "heiße" Kontakt.

Die Verbindung der Kontakte der Laserdiodeneinheit mit den entsprechenden Ausgängen der Lasertreiber-Schaltung erfolgt bevorzugt wiederum über Bonddrähte.

Figur 6 zeigt den Aufbau der Figur 5 im Falle einer Lasereinheit mit einem n-Kontakt-Laserdiodenchip 11a.

In den Figuren 1 bis 6 wurden Schaltungsanordnungen dargestellt, bei denen eine einfache (single-ended) Ansteuerung einer Laserdiode erfolgte. Die nachfolgenden Beispiele der Figuren 6 bis 12 zeigen Anordnungen mit einer differentiellen Ansteuerung einer Laserdiode. Dabei führt eine Lasertreiber-Schaltung jeweils über einen Kontakt HF-A und einen Kontakt HF-B einen differentiellen Modulationsstrom zu und wird über Kontakte Bias-A und Bias-B die Biasstromstromversorgung realisert. Die beiden Kontakte HF-A und HF-B weisen dabei zueinander inverse Signale auf, so daß eine Ansteuerung der Laserdiode mit doppelte Amplitude erfolgt.

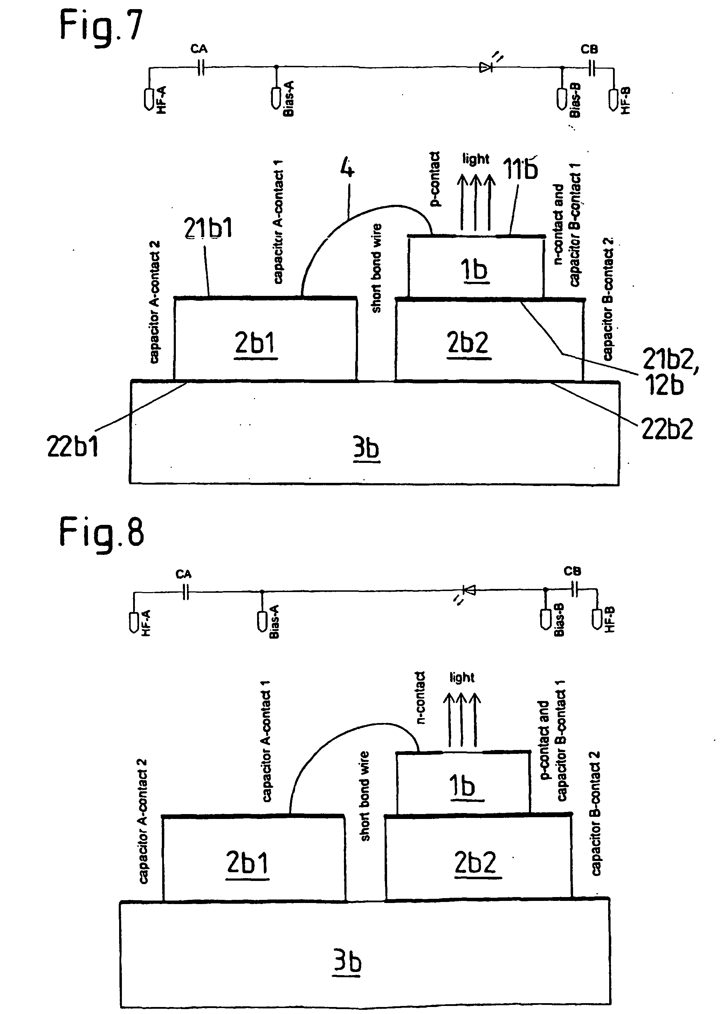

Bei dem Beispiel der Figur 7 sind zwei Koppelkondensatoren 2b1, 2b2 nebeneinander auf einem Submount 3b angeordnet. Über den einen Koppelkondensator 2b2 ist ähnlich wie in der Figur 1 ein p-Kontakt-Laserdiodenchip 1b angeordnet. Vom obenliegenen p-Kontakt 11b des Laserdiodenchips 1b erstreckt sich ein kurzer Bonddraht 4 zum oberen Kontakt bzw. zur oberen Kondensatorfläche 21b1 des anderen Koppelkondensators 2b1. Der HF-Modulationsstrom HF-A liegt am unteren Kontakt 22b2 des linken Koppelkondensators 2b1 und der HF-Modulationsstrom HF-B liegt am unteren Kontakt 22b1 des rechten Koppelkondensators 2b2. Die Bias-Ströme Bias-A und Bias-B werden über die jeweils anderen Kontakte 21b1, 21b2 der Koppelkondensatoren zugeführt.

Figur 8 zeigt die gleiche Situation im Falle eines n-Kontakt-Laserdiodenchips.

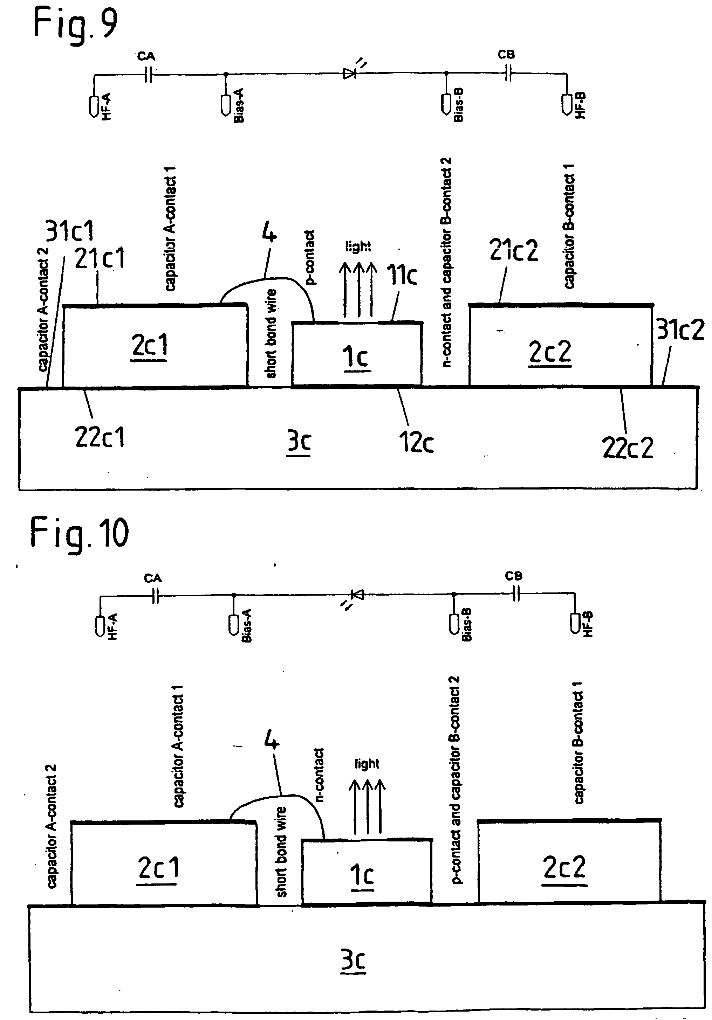

Im Beispiel der Figur 9 sind zwei Koppelkondensatoren 2c1, 2c2 sowie ein Laserdiodenchip 1c jeweils unmittelbar auf einem Submount 3c angeordnet, wobei der Laserdiodenchip 1c zwischen den beiden Koppelkapazitäten 2c1, 2c2 angeordnet ist. Der Submount 3c weist zwei voneinander getrennte Kontaktflächen 31c1, 31c2 auf, wobei auf der einen Kontaktfläche 31c1 der eine Koppelkondensator 2c1 und auf der anderen Kontaktfläche 31c2 der andere Koppelkondensator 2c2 und die Laserdiode 1c mit ihren jeweiligen Kontakten 22ca, 22c2, 12c angeordnet sind. Eine Verbindung zwischen der Laserdiode 1c und der linken Koppelkapazität 2c1 erfolgt wiederum über einen kurzen Bonddraht 4.

Die HF-Modulationsströme HF-A, HF-B werden über den unteren Kontakt 22c1 der linken Koppelkapazität 2c1 und den oberen Kontakt 21c2 der rechten Koppelkapazität 2c2 zugeführt, die Bias-Ströme Bias1, Bias 2 über den oberen Kontakte 21c1 der linken Koppelkapazität 2c1 und die eine Kontaktfläche 31c2 des Submounts 3c, die mit dem unteren n-Kontakt 12c der Laserdiode 1c verbunden ist.

Figur 10 zeigt wiederum die entsprechende Anordnung bei Verwendung eines n-Kontakt-Laserdiodenchips.

Es wird darauf hingewiesen, daß bei den Beispielen der Figuren 1 bis 10 die Koppelkapazität bzw. die Koppelkapazitäten statt als Chipkapazität auch monolithisch in den Submount integriert sein kann. Der Laserchip 1 wird dabei auf dem Submount montiert. Diese Variante weist den Vorteil auf, das eine gesonderte Herstellung und Montage der Koppelkapazitäten nicht erforderlich ist und eine höherere Integrationsdichte erreicht wird. Grundsätzlich ist ebenfalls denkbar, dass auch die Laserdiode monolithisch mit den anderen Komponenten ausgebildet wird.

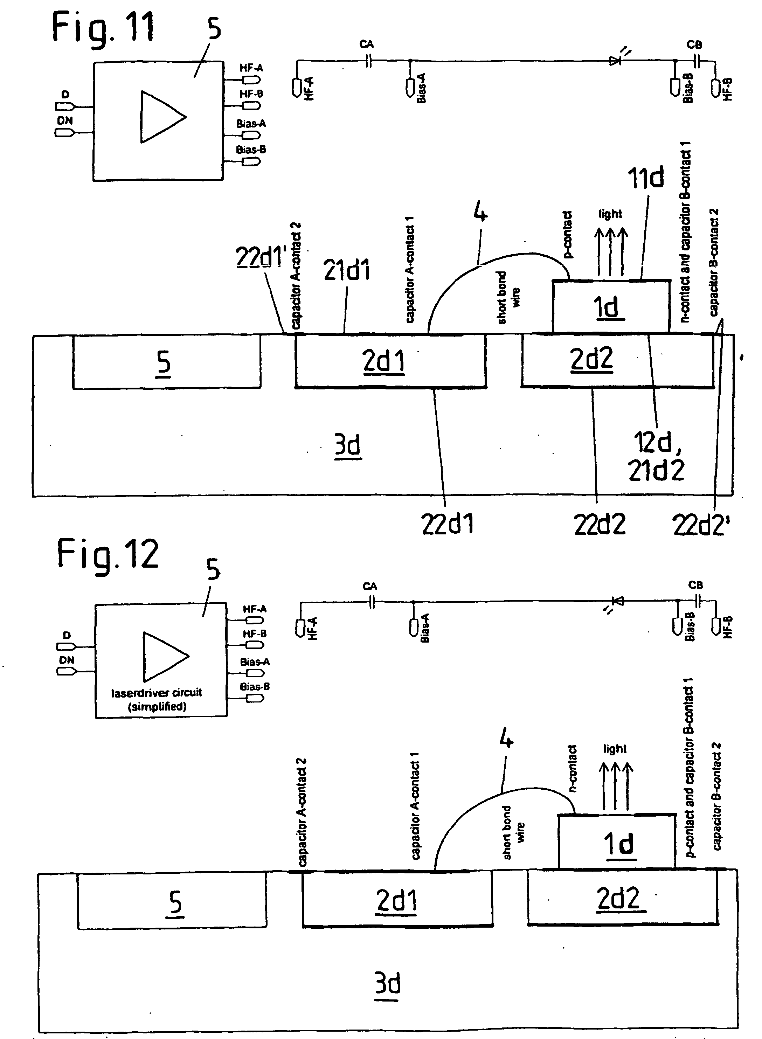

Die Figur 11 zeigt ein Ausführungsbeispiel, bei dem zwei Koppelkondensatoren 2d1, 2d2 in einen Träger 3d integriert sind, der einen Chip mit einem integrierten Schaltkreis darstellt und insbesondere eine Lasertreiber-Schaltung 5 enthält, der zwei zueinander invertierte Eingangssignale D, DN zugeführt werden und die daraus Modulationsströme HF-A, HF-B sowie Bias-Ströme Bias-A , Bias-B zur differentiellen Ansteuerung der Laserdiode 1d generiert.

Die Koppelkondensatoren 2d1, 2d2 weisen jeweils eine an der Oberfläche des integrierten Schaltkreises bzw. Lasertreiber-Ic's ausgebildete Metallisierung 21d1, 21d2 und eine im Inneren des Lasertreiber IC's ausgebildete Metallisierung 22d1, 22d2 auf, wobei letztere jeweils die über eine vertikale Verbindung an die Chip-Oberfläche geführt ist und dort Kontakte 22d1', 22d2' bildet.

Der Laserdiodenchip 1d wird unmittelbar (Chip-on-Chip) auf den integrierten Schaltkreis bzw. Lasertreiber-IC 3d montiert. Dabei ist der untere n-Kontakt 12d der Laserdiode 1d direkt mit einer Metalliserung auf dem Lasertreiber-IC verbunden, die die eine Metallisierung und Kontaktfläche 21d2 des rechten Koppelkondensators 2d2 ausbildet. Beispielsweise wird die Laserdiode 1d durch Klebung mit der rechten Koppelkapazität 2d2 verbunden.

Der andere Anschluss der Laserdiode 1d ist über einen kurzen Bonddraht zum einen Kontakt 21d1 der linken Koppelkapazität 2d1 realisiert.

Die HF-Modulationsströme HF-A, HF-B werden über den mit der unteren Metallisierung 22d1 verbundenen Kontakt 22d1' der linken Koppelkapazität 2d1 und den mit der unteren Metallisierung 22d2 verbundenen Kontakt 22d2' der rechten Koppelkapazität 2d2 zugeführt, die Bias-Ströme Bias1, Bias 2 über den oberen Kontakt 21d1 der linken Koppelkapazität 2d1 und den oberen Kontakt 21d2 der rechten Koppelkapazität 2d2.

Durch die Integration der Koppelkapazitäten in den Lasertreiber-IC 5 können sehr kurze Bondverbindungen (nicht dargestellt) zwischen dem Lasertreiber-IC 5 und der Laserdiode 1d bzw. den Koppelkondensatoren 2d1, 2d2 erfolgen, so dass das Auftreten unerwünschter parasitärer Kapazitäten oder Induktivitäten weiter reduziert wird.

Die Figur 12 schließlich zeigt die Anordnung der Figur 11 für den Fall, daß eine n-Kontakt Laserdiode verwendet wird, wobei der gleiche Aufbau verwendet wird.

Die Erfindung beschränkt sich in ihrer Ausführung nicht auf die vorstehend dargestellten Ausführungsbeispiele.

Beispielsweise sind die speziellen Anordnungen und Verschaltungen vom Submount, Koppelkapazitäten und Laserdiode nur beispielhaft zu verstehen. Auch kann vorgesehen sein, daß eine Integration von Koppelkapazitäten in eine Laserdiodeneinheit erfolgt, bei der mehrere Laserdioden in an sich bekannter Weise in einem Laserdiodenarray angeordnet sind.

## Patentansprüche

1. Laserdiodeneinheit (100) mit
- mindestens einer Laserdiode (1d),
- einem integrierten Schaltkreis (3d) mit einer Oberfläche, auf dem die Laserdiode (1d) angeordnet oder monolithisch ausgebildet ist,
- Anschlusskontakten für die Laserdiode (1d), und
- mindestens einer Koppelkapazität (2d), die in den integrierten Schaltkreis (3d) integriert ist, wobei
- die Koppelkapazität (2d) eine erste, an der Oberfläche des integrierten Schaltkreises ausgebildete Metallisierung (21d1, 21d2) und eine zweite, im Inneren des integrierten Schaltkreises ausgebildete Metallisierung (22d1, 22d2) aufweist, wobei letztere Metallisierung (22d1, 22d2) mit einem elektrischen Kontakt (22d1', 22d2') an einer Oberfläche des integrierten Schaltkreises verbunden ist, und wobei
- die Laserdiode (1d) über die Koppelkapazität (2d) mit einem Signal einer Lasertreiber-Schaltung (5) beaufschlagt wird.

2. Laserdiodeneinheit nach Anspruch 1, **dadurch gekennzeichnet, dass** die Laserdiode (2d) mit einem Anschluss (12d) auf die erste, an der Oberfläche des integrierten Schaltkreises ausgebildete Metallisierung (21d2) gesetzt ist.

3. Laserdiodeneinheit nach Anspruch 2, **dadurch gekennzeichnet, dass** der andere Anschluss (11d) der Laserdiode (1d) durch einen Bondraht (4) realisiert ist.

4. Laserdiodeneinheit nach mindestens einem der Ansprüche 1 bis 3, **dadurch gekennzeichnet, dass** der integierte Schaltkreis (3d) auch eine Lasertreiber-Schaltung (5) für die Laserdiode (1d) enthält.

5. Laserdiodeneinheit nach mindestens einem der Ansprüche 1 bis 4, **dadurch gekennzeichnet, dass** die Laserdiode eine Single-Ended-Ansteuerung erfährt, wobei neben der Laserdiode ein Koppelkondensator vorgesehen ist.

6. Laserdiodeneinheit nach mindestens einem der Ansprüche 1 bis 4, **dadurch gekennzeichnet, dass** die Laserdiode (2d) eine differentielle Ansteuerung erfährt, wobei zwei Koppelkondensatoren (2d1, 2d2) für jede Laserdiode (2d) vorgesehen sind.

7. Laserdiodeneinheit nach mindestens einem der vorangehenden Ansprüche, **dadurch gekennzeichnet, dass** mehrere Laserdioden in ein Laserdioden-Array integriert sind, das zusammen mit dem Träger, den Anschlusskontakten und der mindestens einen Koppelkapazität die Laserdiodeneinheit bildet.

## Claims

1. Laser diode unit (100) having
- at least one laser diode (1d),
- an integrated circuit (3d) with a surface, on which the laser diode (1d) is arranged or formed monolithically,
- connection contacts for the laser diode (1d), and
- at least one coupling capacitance (2d) integrated into the integrated circuit (3d),
- the coupling capacitance (2d) having a first metallization (21d1, 21d2) formed at the surface of the integrated circuit and a second metallization (22d1, 22d2) formed within the integrated circuit, the latter metallization (22d1, 22d2) being connected to an electrical contact (22d1', 22d2') at a surface of the integrated circuit, and
- a signal of a laser driver circuit (5) being applied to the laser diode (1d) via the coupling capacitance (2d).

2. Laser diode unit according to Claim 1, **characterized in that in that** the laser diode (2d) is placed by a connection (12d) onto the first metallization (21d2) formed at the surface of the integrated circuit.

3. Laser diode unit according to Claim 2, **characterized in that** the other connection (11d) of the laser diode (1d) is realized by a bonding wire (4).

4. Laser diode unit according to at least one of Claims 1 to 3, **characterized in that** the integrated circuit (3d) also contains a laser driver circuit (5) for the laser diode (1d).

5. Laser diode unit according to at least one of Claims 1 to 4, **characterized in that** the laser diode experiences single-ended driving, a coupling capacitor being provided in addition to the laser diode.

6. Laser diode unit according to at least one of Claims 1 to 4, **characterized in that** the laser diode (2d) experiences differential driving, two coupling capacitors (2d1, 2d2) being provided for each laser diode (2d).

7. Laser diode unit according to at least one of the preceding claims, **characterized in that** a plurality of laser diodes are integrated into a laser diode array which, together with the carrier, the connection contacts and the at least one coupling capacitance, forms the laser diode unit.

## Revendications

1. Ensemble (100) de diode laser comprenant
- au moins une diode laser (1d) ;
- un circuit (3d) intégré ayant une surface sur laquelle la diode laser (1d) est disposée ou est constituée de manière monolithique ;
- des contacts de borne pour la diode laser (1d) ; et
- au moins une capacité (2d) de couplage qui est intégrée au circuit (3d) intégré, dans lequel
- la capacité (2d) de couplage a une première métallisation (21d1, 21d2) constituée à la surface du circuit intégré et une deuxième métallisation (22d1, 22d2) constituée à l'intérieur du circuit intégré, la dernière métallisation (22d1, 22d2) étant reliée par un contact (22d1', 22d2') électrique à une surface du circuit intégré, et dans lequel
- la diode laser (1d) est alimentée par l'intermédiaire de la capacité (2d) de couplage en un signal d'un circuit (5) d'attaque laser.

2. Ensemble de diode laser suivant la revendication 1, **caractérisé en ce que** la diode laser (2d) est posée par une borne (12d) sur la première métallisation (21d2) constituée à la surface du circuit intégré.

3. Ensemble de diode laser suivant la revendication 2, **caractérisé en ce que** l'autre borne (11d) de la diode laser (1d) est réalisée par un fil (4) de liaison.

4. Ensemble de diode laser suivant au moins l'une des revendications 1 à 3, **caractérisé en ce que** le circuit (3d) intégré comporte aussi un circuit (5) d'attaque laser pour la diode laser (1d).

5. Ensemble de diode laser suivant au moins l'une des revendications 1 à 4, **caractérisé en ce que** la diode laser subit une excitation single-ended, un condensateur de couplage étant prévu à côté de la diode laser.

6. Ensemble de diode laser suivant au moins l'une des revendications 1 à 4, **caractérisé en ce que** la diode laser (2d) subit une excitation différentielle, deux condensateurs (2d1, 2d2) de couplage étant prévus pour chaque diode laser (2d).

7. Ensemble de diode laser suivant au moins l'une des revendications précédentes, **caractérisé en ce que** plusieurs diodes lasers sont intégrées dans un réseau de diodes lasers qui, ensemble avec le support, le contact de borne et la au moins une capacité de couplage, forme l'ensemble de diode laser.
